# EUROPEAN PATENT SPECIFICATION

(11) **EP 0 227 085 B1**
(45) Date of publication and mention of the grant of the patent: **25.08.1993**
(21) Application number: 86117863.0
(22) Date of filing: 22.12.1986
(51) Int. Cl.: H01L 21/20, H01L 21/324, H01L 21/285

(54) **A method of manufacturing IGFETs having minimal junction depth using epitaxial recrystallization**
Verfahren zum Herstellen von IGFETs mit minimaler Übergangstiefe durch epitaktische Rekristallisation
Procédé pour fabriquer des IGFETs avec une profondeur de jonction minimale réalisé par recristallisation épitaxiale

(30) Priority: 23.12.1985 IT 2335685
(43) Date of publication of application: 01.07.1987
(73) Proprietor: SGS MICROELETTRONICA S.p.A., 95121 Catania (IT)
(72) Inventor: Meda, Laura, Phys. Dr., I-20144 Milano (IT)
(74) Representative: Klunker . Schmitt-Nilson . Hirsch

(56) References cited:
- US-A- 4 463 492
- US-A- 4 542 580
- US-A- 4 588 447

## Description

The present invention relates to a method for manufacturing an insulated gate field effect transistor (IGFET); particularly, to a method for manufacturing an IGFET having an improved response speed within integrated circuits of high integration density.

In order to obtain a high degree of integration density and an elevated response speed it is necessary to reduce the horizontal and vertical dimensions of the IGFETs. This is called the "scaling principle". Particularly, it is necessary to reduce the junction depth of the drain and the source within the substrate. In conventional IGFETs, the use of very thin junctions also leads to certain drawbacks. The layer resistance of the active regions is elevated and the reliability of the contacts between the active regions and the corresponding electrodes is reduced.

In order to avoid the above-mentioned drawbacks, an IGFET has already been proposed in which the active regions of the source and the drain are formed above the surface of the substrate rather than within the substrate. A structure of this type may be obtained by means of selective epitaxy as disclosed in German patent application P 35 25 550.1 of the applicant of the present application. However, the manufacture of such structures necessitates special reactors which are capable of creating, in a reproducible manner, very thin epitaxial layers from the gaseous phase. Moreover, highly selective etchants are required to define the grown monocrystalline regions. The reactors are very expensive. Furthermore, the temperature at which epitaxial growth is achieved is relatively high (1150°C).

The above-mentioned German patent application also describes a process in which the active regions of the source and the drain are obtained by recrystallization of a layer of deposited polycrystalline silicon by means of a laser, rather than by means of epitaxial growth. However, in an industrial manufacturing process recrystallization by means of a laser is not suitable for large-scale production.

From document US-A-4,542,580 a method of fabricating N-type silicon regions and associated contacts has come to be known, wherein an amorphous silicon layer is deposited on a monocrystalline silicon substrate having a patterned silicon dioxide layer on its surface. The amorphous silicon layer is then selectively molten by means of a heating laser or electron beam. During the cooling of the amorphous silicon layer, there is a "self-annealing" and resolidification of the cooling silicon in form of monocrystalline silicon in the regions where the amorphous silicon layer contacts the monocrystalline silicon substrate, and in form of amorphous silicon in those regions where the monocrystalline silicon substrate is covered by silicon dioxide. As already mentioned above, in an industrial manufacturing process recrystallization by means of a laser or electron beam is not suitable.

From document US-A-4,463,492 a method of forming a semiconductor device on insulating substrate by selective amorphosization followed by simultaneous activation and reconversion to single crystal state has come to be known. The main features of this method are: A monocrystalline silicon layer is grown on an insulating substrate. By means of thermal oxidation, the monocrystalline silicon layer is covered by a silicon dioxide layer. Then, by means of an ion implantation, a thickness part of the monocrystalline silicon layer, which is adjacent to the insulating substrate, is changed to amorphous silicon. The remaining thickness portion of the monocrystalline silicon layer, which is adjacent to the thermal oxide layer, remains monocrystalline silicon. After that, a gate electrode is deposited onto the thermal outside layer. The silicon is doped by means of an arsenic ion implantation, using the gate electrode as a doping mask. Finally, the silicon is annealed which results in the solid phase growth of monocrystalline silicon from the amorphous silicon. The monocrystalline silicon adjacent to the thermal oxide layer which was not changed to amorphous silicon, has the function of a crystallization seed for the solid phase grown monolithic silicon. However, this known method per se is not suitable for manufacturing insulated gate field effect transistors (IGFETs) with shallow junction depth.

The problem underlying the present invention is to provide a method of manufacturing insulated gate field effect transistors having minimal junction depth, the method being more economical than the prior art methods and allowing for the manufacture of reliable devices.

This problem is solved by the present invention defined in claim 1. Preferred embodiments of the invention are defined in the sub-claims.

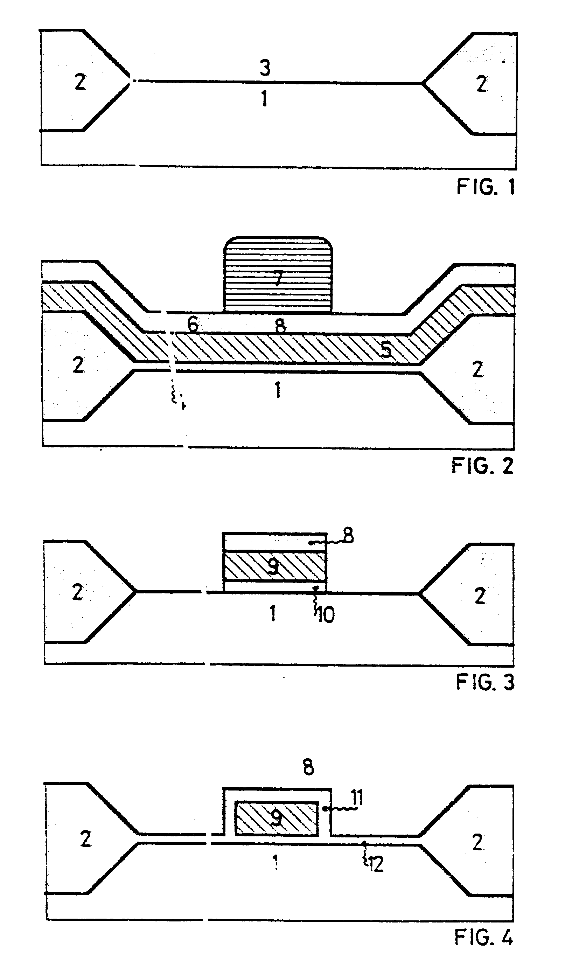

Embodiments of the invention shall be described in more detail in the following with reference to the drawings. Figures 1, 2, 3, 4, 5, 6, 7 and 8 show schematic sectional views illustrating successive stages in a manufacturing process for obtaining an IGFET.

As shown in Fig. 1, the basic structure of the transistor is obtained using conventional techniques. The structure comprises a substrate 1 of monocrystalline silicon of P-type conductivity having a low impurity concentration (about 10¹⁵ atoms/cm³).

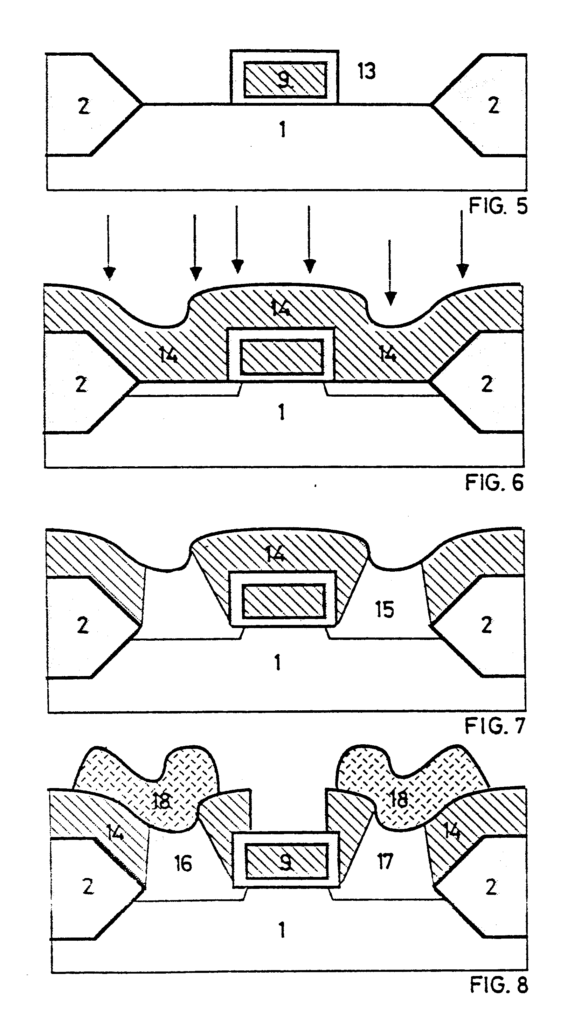

Within substrate 1 a localized region 3 is formed for receiving the IGFET. Outside the region 3 the substrate is covered by a layer 2 of silicon dioxide (SiO₂), which constitutes a field dielectric, the purpose of which is to separate the active zone from other zones. Referring to Figures 2 to 5, the following successive process steps are carried out, starting from the above-mentioned structure:
- thermal oxidation at a temperature of about 1000°C of the exposed surface of substrate 1 to form a silicon dioxide layer 4 (Fig. 2) having a thickness of about 30 nm; this layer is intended to constitute the dielectric (insulating) material of the gate of the complete transistor;
- depositing from silane hydrogen (SiH₄) a polycrystalline silicon layer 5 (Fig. 2) having a thickness of about 500 nm. The deposition is carried out using the well-known LPCVD process (low pressure chemical vapor deposition) at a temperature of about 600°C;
- doping polycrystalline silicon layer 5 by way of a predeposition of phosphorous chlorine oxide (POCl₃) at a temperature of about 920°C. The impurity concentration (N-type) is in the order of 10²⁰ atoms/cm³;
- diffusion of the impurity into polycrystalline silicon layer 5 and creation of a thin silicon dioxide layer 6 (Fig. 2) having a thickness of a few tens of nanometers; this is done by exposing the material to an oxidizing environment at a temperature of about 1000°C;
- forming (by means of well-known photolithographic techniques) a photoresist mask 7 which protects a localized area 8 of silicon dioxide layer 6. The mask delimits a gate area of the IGFET located above a region of the substrate which is intended for the channel of the transistor (Fig. 3);
- removing the non-protected portions of layers 6, 5, 4 by using selective chemical or physical etchants (wet etching or plasma etching), delimiting a portion 8 of silicon dioxide, a portion 9 of polycrystalline silicon, a portion 10 of gate oxide (which defines the gate) located above said localized area;
- thermally oxidizing the exposed surface portions of the silicon at a relatively low temperature (about 800°C) to create an oxide layer the thickness of which depends on the impurity concentration within the silicon. At the sides and on the surface of said portion 9 of polycrystalline silicon in which the impurity concentration is about 10²⁰ atoms/cm³, a silicon dioxide layer 11 may grow having a thickness of about 150 nm, while on the exposed surface of substrate 1 in which the impurity concentration is about 10¹⁵ atoms/cm³, a silicon dioxide layer 12 grows which has a thickness of about 35 nm (Fig. 4);
- chemically etching the silicon oxide in order to remove layer 12 completely, uncovering the surface portions of substrate 1 where the oxide layer is relatively thin (e.g. using diluted fluorine acid). However, this etching step does not uncover portion 9 of polycrystalline silicon, since this portion is covered by relatively thick oxide material. Portion 9 of polycrystalline silicon which is used to form the gate electrode of the IGFET is therefore completely surrounded by silicon dioxide 13 as shown in Fig. 5. The thickness of field oxide 2 is not significantly reduced. The purpose of this etching step is to prepare the surface of the monocrystalline silicon for a subsequent deposition of polycrystalline silicon.

The following operations are now performed according to the present invention:
- deposition of a polycrystalline silicon layer 14 having a predetermined thickness (about 500 nm) using a low pressure furnace (LPCVD), as shown in Fig. 6;
- ion implantation, indicated symbolically in Fig. 6 by means of vertical arrows. The implantation uses an atomic species suitable for rendering the polycrystalline silicon layer amorphous. The implantation takes place with such an energy that the implanted impurities somewhat exceed the interface between the polycrystalline material and the monocrystalline material. This is indicated in Fig. 6 by a continuous line. The implantation dose must be selected so as to obtain a completely amorphous polycrystalline silicon layer;
- thermal recrystallization treatment at a temperature between 450 and 600°C in order to achieve total recrystallization of implanted layer 15 to monocrystalline silicon by way of solid phase epitaxy. As shown in Fig. 7, the epitaxy does not take place within the region above the silicon dioxide layer (SiO₂) where remains polycrystalline silicon 14.

The following steps are conventional process steps for forming a photoresist mask and removing the excess polycrystalline silicon using a chemical etchant (or plasma etching). As shown in Fig. 8, the source and drain regions of the final transistor are thereby formed. Using similar techniques, interconnection stripes are formed. Finally, metallization 18 is formed which constitutes the contacts of source and drain 16, 17, as shown in Fig. 8.

In the process of the present invention the doping material is implanted shallowly into the regions of polycrystalline silicon 16, 17, so that subsequent thermal treatments at elevated temperatures do not provoke the diffusion of the dopant material into substrate 1, and the junctions of the source and the drain do not descend below the interface of the gate oxide and the substrate. Thus situated, the junctions do not act as lateral junctions. The lack of the ability to act as lateral junctions allows for a high response speed of the transistor to be obtained. Moreover, the depletion zones, instead of extending laterally as they usually do in an IGFET, extend vertically below the active regions, thereby increasing the effective length of the transistor and diminishing the risk of a punch-through.

An important advantage of the present invention is that instead of using an epitaxially grown silicon produced in special reactors at high temperatures of 1150°C, polycrystalline silicon is used, which is normally deposited at relatively low temperatures, to realize the source and drain contacts of the field effect transistors.

The epitaxial regrowth of the initially deposited layer is achieved relatively easily by transforming the polycrystalline silicon into monocrystalline silicon. After the layer material has been rendered amorphous by the ion implantation it is sufficient to bring the material to a relatively low temperature (500-600°C) to obtain regrowth of the deposited layer, in alignment with the crystallic orientation of the substrate. A further effect of such a treatment is an improvement in the resistance value of the formed layer, compared with the resistance value of the polycrystalline silicon itself.

While the present invention allows for the realization, without any particular efforts, of a level of interconnection of the polycrystalline silicon within the external zones on the substrate, this is not possible using the above-mentioned prior art method, since in epitaxial reactors it is not possible to form polycrystalline silicon from the gaseous phase in these external zones on the substrate.

With respect to typical structures of standard transistors (N-MOS and C-MOS) which have not been described in this application but are well-known to those skilled in the art, the following advantages are achieved. A more planar structure is obtained, thereby avoiding harsh steps for the metallization. The problem of contact between the metallization and a thin junction is eliminated in so far as the junction obtained by the present invention is thick but has a depth of substantially 0. Finally, a rule of design defining the smallest gate contact distance is eliminated, since it is no longer critical.

## Claims

1. A process for producing an insulated gate field effect transistor on a first region (3) of a monocrystalline silicon substrate (1) of a first type of conductivity, comprising the steps of:
(a) forming a first insulating layer (10) on a second region (8) confined in said first region (3);
(b) forming a conductive layer (9) on said first insulating layer (10);
(c) forming an amorphous silicon layer (14) over the thus obtained structure, said layer containing impurities causing it to have a second type of conductivity which is opposed to said first type of conductivity;
(d) performing a heat treatment step for causing an epitaxial recrystallization into monocrystalline silicon of those parts of the amorphous silicon layer (14) in contact with the substrate (1), the recrystallized monocrystalline silicon parts (16, 17) forming drain (16) and source (17) regions of said field effect transistor,
**characterized in that**:
said step (b) of forming a conductive layer (9) on said first insulating layer further comprises:
(ba) forming a second insulating layer (8) on top of said conductive layer (9);
(bb) forming insulating walls (11) on at least the uncovered portions, including the edges, of the conducting layer (9);
said amorphous silicon layer (14) formed in step (c) is obtained by performing the following steps:
(ca) forming a polycrystalline silicon layer (14),
(cb) implanting said polycristalline silicon layer (14) with said impurities causing it to have a second type of conductivity which is opposite to the first type of conductivity, wherein the atomic species of the impurities, the concentration thereof and the implantation energy are selected (i) so as to inject said impurities into the substrate (1) in those areas where the substrate (1) is in contact with said polycristalline silicon layer (14) and (ii) so as to cause the conversion of the polycristalline silicon layer to amorphous silicon;
said heat treatment step (d) is a low temperature heat treatment step.

2. Method according to claim 1, characterized in that the atomic species of the impurity material used for the ion implantation is arsenic.

3. Method according to claim 1 or 2, characterized in that the thermal treatment temperature is in the range from 450°C to 600°C.

4. Method according to claim 3, characterized in that the thermal treatment is carried out at a temperature of 600°C.

## Patentansprüche

1. Verfahren zum Herstellen eines Feldeffekttransistors mit isoliertem Gate auf einem ersten Bereich (3) eines monokristallinen Siliziumsubstrats (1) eines ersten Leitfähigkeitstyps, mit folgenden Schritten:
(a) Bilden einer ersten Isolierschicht (10) auf einem in dem ersten Bereich (3) festgelegten zweiten Bereich (8);
(b) Bilden einer leitfähigen Schicht (9) auf der ersten Isolierschicht (10);
(c) Bilden einer amorphen Siliziumschicht (14) über der auf diese Weise erzielten Struktur, wobei die Schicht Fremdstoffe enthält, die dieser einen zweiten Leitfähigkeitstyp verleihen, der dem ersten Leitfähigkeitstyp entgegengesetzt ist;
(d) Ausführung eines Wärmebehandlungsschrittes zum Verursachen einer epitaxialen Rekristallisierung der mit dem Substrat (1) in Kontakt stehenden Teile der amorphen Siliziumschicht (14) in monokristallines Silizium, wobei die Teile (16, 17) aus rekristallisiertem monokristallinen Silizium den Drainbereich (16) und den Sourcebereich (17) des Feldeffekttransistors bilden,
dadurch gekennzeichnet, daß der Schritt (b) der Bildung einer leitfähigen Schicht (9) auf der ersten Isolierschicht weiterhin umfaßt:
(ba) Bilden einer zweiten Isolierschicht (8) oben auf der leitfähigen Schicht (9);
(bb) Bilden von isolierenden Wänden (11) wenigstens auf den unbedeckten Bereichen, einschließlich der Ränder, der leitfähigen Schicht (9);
daß die in Schritt (c) gebildete amorphe Siliziumschicht (14) durch Ausführen folgender Schritte erzielt wird:
(ca) Bilden einer Schicht (14) aus polykristallinem Silizium,
(cb) Implantieren der Fremdstoffe in die Schicht (14) aus polykristallinem Silizium, so daß diese einen zweiten Leitfähigkeitstyp erhält, der dem ersten Leitfähigkeitstyp entgegengesetzt ist, wobei die Atomart der Fremdstoffe, die Konzentration derselben sowie die Implantationsenergie derart gewählt werden, daß (i) die Fremdstoffe in diejenigen Bereiche des Substrats (1) injiziert werden, in denen sich das Substrat (1) mit der Schicht (14) aus polykristallinem Silizium in Kontakt befindet, und (ii) eine Umwandlung der Schicht aus polykristallinem Silizium in amorphes Silizium hervorgerufen wird;
und daß es sich bei dem Wärmebehandlungsschritt (d) um einen bei niedriger Temperatur erfolgenden Wärmebehandlungsschritt handelt.

2. Verfahren nach Anspruch 1,
dadurch gekennzeichnet, daß es sich bei der Atomart des für die Ionenimplantation verwendeten Fremdstoffmaterials um Arsen handelt.

3. Verfahren nach Anspruch 1 oder 2,
dadurch gekennzeichnet, daß die Wärmebehandlungstemperatur im Bereich von 450 °C bis 600 °C liegt.

4. Verfahren nach Anspruch 3,
dadurch gekennzeichnet, daß die Wärmebehandlung bei einer Temperatur von 600 °C durchgeführt wird.

## Revendications

1. Procédé de fabrication d'un transistor à effet de char à grille isolée sur une prière région (3) d'un substrat de silicium monocristallin (1) d'un premier type de conductivité, comprenant les étapes suivantes :
a) former une première couche isolante (10) sur une seconde région (8) confinée dans la première région (3);
b) former une couche conductrice (9) sur la première couche isolante (10);
c) former une couche de silicium amorphe (14) sur la structure ainsi obtenue, cette couche contenant des impuretés l'amenant à avoir un second type de conductivité opposé au premier type de conductivité ;
d) réaliser une étape de traitement thermique pour provoquer une recristallisation épitaxiale en silicium monocristallin des parties de la couche de silicium amorphe (14) qui sont en contact avec le substrat (1), les parties de silicium monocristallin recristallisées (16, 17) formant les régions de drain (16) et de source (17) du transistor à effet de champ,
caractérisé en ce que :
l'étape b) de formation d'une couche conductrice (9) sur la première couche isolante comprend en outre :
ba) former une deuxième couche isolante (8) sur ladite couche conductrice (9) ;
bb) former des parois isolantes (11) sur au moins les parties découvertes, incluant les bords, de la couche conductrice (9) ;
la couche de silicium amorphe (14) formée à l'étape (c) est obtenue en réalisant les étapes suivantes :
ca) former une couche de silicium polycristallin (14),
cb) implanter dans la couche de silicium polycristallin (14) des impuretés l'amenant à avoir un second type de conductivité opposé au premier type de conductivité, les atomes d'impuretés, leur concentration et leur énergie d'implantation étant choisis pour (i) injecter les impuretés dans le substrat (1) dans les zones où le substrat (1) est en contact avec la couche de silicium polycristallin (14) et (ii) provoquer la conversion de la couche de silicium polycristallin en silicium amorphe ;
l'étape de traitement thermique (d) est une étape de traitement thermique à basse température.

2. Procédé selon la revendication 1, caractérisé en ce que les atomes d'impuretés utilisés pour l'implantation ionique sont de l'arsenic.

3. Procédé selon la revendication 1 ou 2, caractérisé en ce que la température du traitent thermique est comprise dans la plage allant de 450°C à 600°C.

4. Procédé selon la revendication 3, caractérisé en ce que le traitement thermique est effectué à une température de 600°C.
